# EUROPEAN PATENT APPLICATION

(11) **EP 3 489 383 A1**
(43) Date of publication of application: **29.05.2019**
(21) Application number: 17203078.5
(22) Date of filing: 22.11.2017
(51) Int. Cl.: C23C 4/10, C23C 4/18, C23C 24/04, C23C 24/08, C23C 28/02, C23C 28/00, C23C 30/00, C23C 4/131, C23C 4/129, C23C 4/134, F24S 70/20

(54) **COATED COMPONENTS OF SOLAR POWER SYSTEMS**

(71) Applicant: General Electric Technology GmbH, 5400 Baden (CH)
(72) Inventor: BAHRAINI HASANI, Maryam, 5400 Baden (CH); PARCIANELLO, Giulio, 5400 Baden (CH)
(74) Representative: Katzka, Catherine

(57) **Abstract**

A component includes a substrate and a coating system. The coating system includes a base layer that includes at least one of a (M1)AX phase and a (M2)CrX composition. The coating system also includes a top layer that includes a black pigment embedded in a matrix. The matrix is one of a metal-based matrix and a ceramic-based matrix.

## Description

### BACKGROUND

The present disclosure relates generally to coated components and, more particularly, to coatings for solar power system components.

At least some solar thermal technology concentrates solar radiation using mirrors (also referred to as "heliostats") to direct solar radiation to a central tower receiver. In the central tower receiver (also referred to as the "central solar power system"), solar energy is absorbed as heat and converted into electricity. Within the central tower receiver are heat exchangers for transferring the collected heat to a heat transfer fluid, which is then used, for example, to produce steam to run a turbine and extract work to produce electricity.

Due to the amount of energy directed to a typical central solar power system, the central solar power system must be able to withstand operating temperatures of 500 °C or more while retaining high absorptivity. To improve the stability of the materials in the central solar power system at high temperatures and the absorptivity of the materials, at least some known components of central solar power system, such as known heat exchanger tubes, include polymer-based coatings that convert into ceramic-based materials after a heat treatment above approximately 400 °C. However, the polymer-to-ceramic conversion is generally associated with an overall coating shrinkage and may generate a micro- and/or macro-cracked structure that reduces the structural stability and/or performance of the component.

In addition, during operation at high temperatures, at least some known coated components are subject to oxidation, which interferes with the performance of the component. For example, an oxide layer formed at the interface between a heat exchanger substrate and coating may adversely affect mechanical properties (e.g., mechanical adhesion) and thermal heat transfer (e.g., heat transfer coefficient of the coating) of the system. For instance, polymer-based coatings may not vitrify completely, leaving the coating with relatively low oxidation resistance.

### BRIEF DESCRIPTION

In one aspect, a component is provided. The component includes a substrate and a coating system. The coating system includes a base layer that includes at least one of a (M1)AX phase and a (M2)CrX composition. The coating system also includes a top layer that includes a black pigment embedded in a matrix. The matrix is at least one of a metal-based matrix and a ceramic-based matrix.

In another aspect, a solar power system is provided. The solar power system includes a central solar receiver that includes at least one heat exchanger component. The solar power system also includes at least one heliostat configured to reflect solar energy toward the central solar receiver. The at least one heat exchanger component includes a substrate and a coating system. The coating system includes a base layer that includes at least one of a (M1)AX phase and a (M2)CrX composition. The coating system also includes a top layer that has a coefficient of absorption of solar radiation of at least 90 percent.

In yet another aspect, a method of making a component is provided. The method includes applying a base layer onto an outer surface of a substrate of the component. The base layer includes at least one of a (M1)AX phase and a (M2)CrX composition. The method also includes applying a top layer onto an outer surface of the base layer. The top layer includes a black pigment embedded in a matrix. The matrix is at least one of a metal-based matrix and a ceramic-based matrix.

### BRIEF DESCRIPTION OF THE DRAWINGS

FIG. 1 is a schematic of an exemplary embodiment of a solar power system including a heat exchanger component.

FIG. 2 is a schematic cross-sectional view of a portion of an exemplary heat exchanger component that may be used with the solar power system shown in FIG. 1.

FIG. 3 is a schematic cross-sectional view of a portion of another exemplary heat exchanger component that may be used with the solar power system shown in FIG. 1.

FIG. 4 is a schematic cross-sectional view of a portion of another exemplary heat exchanger component that may be used with the solar power system shown in FIG. 1.

FIG. 5 is a schematic cross-sectional view of a portion of another exemplary heat exchanger component that may be used with the solar power system shown in FIG. 1.

FIG. 6 is a flow chart of an exemplary method of making a coated component.

### DETAILED DESCRIPTION

Embodiments of the present disclosure provide advantages over at least some coated components used in solar power systems. The components include a coating system that includes a base layer and a top layer. The base layer includes at least one of a MAX-phase and a MCrX composition, and is tailored for oxidation and corrosion resistance to protect a substrate of the component, as well as high heat conductivity to convey energy absorbed by the top layer. The top layer provides high absorptivity and low emissivity.

Unless otherwise indicated, approximating language, such as "generally," "substantially," and "about," as used herein indicates that the term so modified may apply to only an approximate degree, as would be recognized by one of ordinary skill in the art, rather than to an absolute or perfect degree. Approximating language may be applied to modify any quantitative representation that could permissibly vary without resulting in a change in the basic function to which it is related. Accordingly, a value modified by a term or terms, such as "about," "approximately," and "substantially," is not to be limited to the precise value specified. In at least some instances, the approximating language may correspond to the precision of an instrument for measuring the value. Here and throughout the specification and claims, range limitations may be identified. Such ranges may be combined and/or interchanged, and include all the sub-ranges contained therein unless context or language indicates otherwise.

Additionally, unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

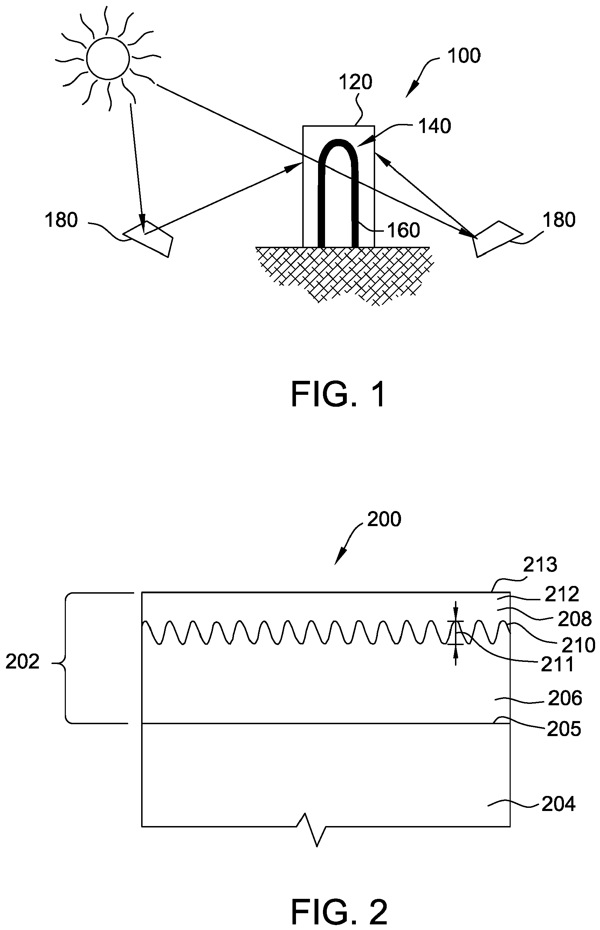

FIG. 1 is a schematic of a solar power system 100 including a heat exchanger component 160. More specifically, solar power system 100 includes a central solar receiver 120 that includes at least one heat exchanger component 160 through which a heat transfer fluid (not shown) flows. As used herein, "heat exchanger component" or "heat exchanger components" generally refers to one or more components configured to transfer solar energy to a heat transfer fluid. In the exemplary embodiment, heat exchanger components 160 have elongated cylindrical bodies. In alternative embodiments, heat exchanger components 160 have any suitable shape, such as an elongated body having a rectangular cross-section or otherwise. In the exemplary embodiment, heat exchanger components 160 are made of metal, such as steel or superalloys (e.g., nickel- based superalloys, cobalt-based superalloys, or iron-based superalloys). In alternative embodiments, heat exchanger components 160 are made from any other material suitable for withstanding the associated high temperatures.

In the exemplary embodiment, the at least one heat exchanger component 160 is at least partially coated with a coating system 140. Solar energy is reflected by at least one heliostat 180 to central solar receiver 120, where the solar energy heats the heat transfer fluid flowing through the at least one heat exchanger component 160. The heated heat transfer fluid is then used, for example, to create electricity by any of a variety of different suitable methods as known in the art. It should be understood that coating system 140 may coat each heat exchanger component 160 fully, or partially to any suitable degree, without deviating from the scope of the present disclosure.

FIG. 2 is a schematic cross-sectional view of a portion of an exemplary embodiment of heat exchanger component 160 (shown in FIG.1), designated as component 200. In particular, component 200 includes coating system 140 (shown in FIG. 1), designated as coating system 202. Although component 200 is heat exchanger component 160 in the exemplary embodiment, in alternative embodiments, component 200 is any suitable component for any suitable application in which component 200 is configured to absorb reflected radiation in the solar spectrum.

In the exemplary embodiment, coating system 202 is disposed on an outer surface 205 of substrate 204. Substrate 204 refers generally to a structural base of component 200, and is made from a metal or other suitable material. Outer surface 205 is an outermost surface of component 200 which would be exposed to the environment without the described coating system 202. For example, in some embodiments substrate 204 includes a plurality of layers (not shown) of materials, and outer surface 205 of substrate 204 is the surface of the outermost layer.

In the exemplary embodiment, coating system 202 includes a base layer 206 disposed on outer surface 205 of substrate 204, and extending outward from outer surface 205 to an outer surface 210 of base layer 206. Coating system 202 further includes a top layer 208 disposed on, and in contact with, outer surface 210 of base layer 206.

Base layer 206 is configured to protect substrate 204 against oxidation and corrosion. In certain embodiments, base layer 206 includes at least one of a MAX-phase and a MCrX composition. To facilitate distinguishing between the elements that may serve as the "M" in each type of material, MAX-phase materials will be referred to herein as (M1)AX-phases, and MCrX compositions will be referred to herein as (M2)CrX compositions. In the exemplary embodiment, base layer 206 does not contribute substantially to the overall absorptivity of coating system 202. For example, base layer 206 does not include a black pigment embedded in or otherwise added to the MAX-phase and/or the MCrX composition. In alternative embodiments, base layer 206 contributes to the overall absorptivity of coating system 202 to any suitable extent.

(M1)AX-phases are a class of ceramic materials characterized by a coefficient of thermal expansion ("CTE") greater than 8 . 10⁻⁶ K⁻¹, a thermal conductivity greater than 15 W/m . K at 700°C, a fracture toughness ("Kic") greater than 5 MPa . m^{1/2}, and a high oxidation resistance. (M1)AX-phase materials have an (M1)ₙ₊₁AXₙ formula, where n =1, 2, or 3; M1 is an early transition metal such as Ti, V, Cr, Zr, Nb, Mo, Hf, Sc, or Ta; A is an A-group element such as Al, Si, P, S, Ga, Ge, As, Cd, In, Sn, Tl, or Pb; and X is C and/or N.

(M2)CrX compositions are characterized by a CTE in a range of about 10 . 10⁻⁶ K⁻¹ to about 20 . 10⁻⁶ K⁻¹ at a temperature in a range of about 500°C to 1000°C, a thermal conductivity greater than 10 W/m . K, and a high oxidation resistance. (M2)CrX compositions include M2 being Ni, Co, Fe, or any combination thereof; Cr being chromium; and X being Al, Ti, Si, Ta, Nb, Mo, W, Mn, Y, B, or any combination thereof. In the exemplary embodiment, the (M2)CrX composition includes M2 ranging from about 40 percent to about 85 percent by weight, Cr ranging from about 5 percent to about 45 percent by weight, and X ranging from about 0.5 percent to about 21 percent by weight.

In the exemplary embodiment, base layer 206 has a thickness in a range from about 30 µm to about 500 µm. In alternative embodiments, base layer 206 has any suitable thickness that enables base layer 206 to function as described herein.

In the exemplary embodiment, base layer 206 has a porosity in a range from about 0.5 percent to about 20 percent. In alternative embodiments, base layer 206 has any suitable porosity that enables base layer 206 to function as described herein.

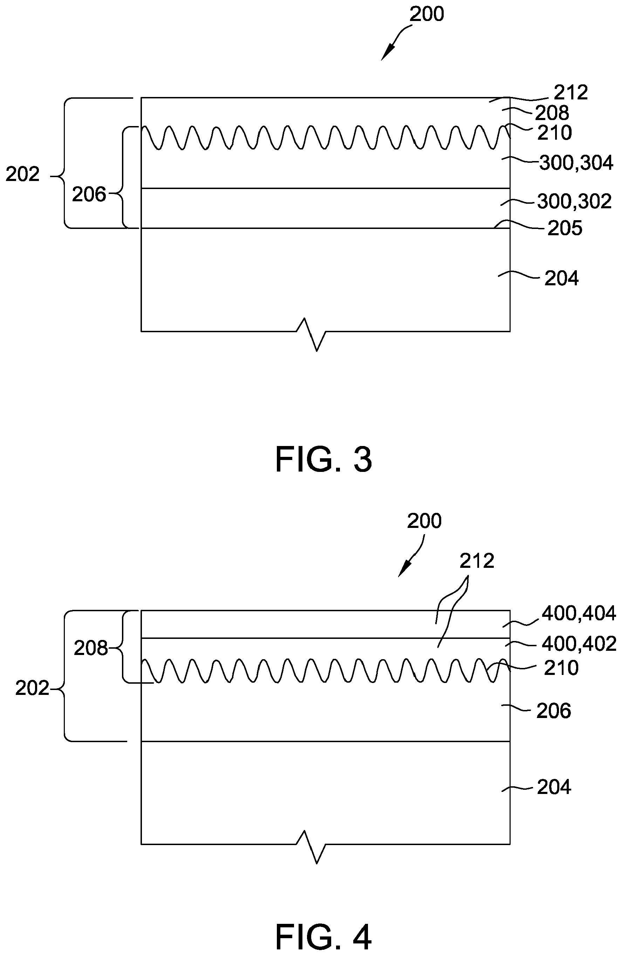

In the exemplary embodiment, base layer 206 is disposed on outer surface 205 of substrate 204 by any suitable method, such as but not limited to cold gas spray (GDCS), thermal spray (e.g., atmospheric plasma spray (APS), high velocity oxygen fuel (HVOF), or high velocity air fuel (HVAF)), wire-arc spray, plasma electrolytic oxidation (PEO), electroplating, electroless plating, sheet brazing, laser cladding, slurry-based methods, or any combination thereof. In the exemplary embodiment, base layer 206 is formed as a single layer. In alternative embodiments, base layer 206 is formed with multiple layers, one example of which is illustrated in FIG. 3 and discussed further below.

In certain embodiments, a topography of outer surface 210 of base layer 206 is configured to enhance an adhesion of top layer 208 to base layer 206 by mechanical interlocking. For example, outer surface 210 includes a plurality of surface features 211 that each define a peak-to-valley depth in a range of from about 2 µm to about 50 µm. In alternative embodiments, surface features 211 each define any suitable peak-to-valley depth that enables base layer 20 to function as described herein. In other alternative embodiments, base layer 206 does not include surface features 211.

In some embodiments, the topography of outer surface 210 is formed during deposition of base layer 206. In other embodiments, the topography of outer surface 210 is formed at least partially in a post-deposition process.

In the exemplary embodiment, top layer 208 includes a black pigment 213 embedded in a matrix 212. Top layer 208 is configured to define selected optical properties, such as absorptivity and emissivity, of component 200. In certain embodiments, black pigment 213 includes any combination of oxide ceramic materials and/or non-oxide ceramic materials. More specifically, in some embodiments, black pigment 213 includes one or more non-oxide ceramic materials, while in other embodiments, black pigment 213 includes one or more oxide ceramic materials, and in still other embodiments, black pigment 213 includes at least one non-oxide ceramic material and at least one oxide ceramic material. Oxide ceramic materials are ceramic materials that include an oxide component, such as Co₃O₄, TiO₂, SiO₂, Fe₂O₃, Fe₃O₄, Mn₂O₃, and CuO. In contrast, non-oxide ceramic materials are materials that lack an oxide component, such as SiC, Si₃N₄, Ti₃SiC₂, Ti₄SiC₃, Ti₂AlC, Ti₃AlC₂, Cr₂AlC, carbon-black, carbon nanotubes, and graphene. In alternative embodiments, black pigment 213 includes any suitable material that enables top layer 208 to function as described herein. For example, in certain embodiments, top layer 208 has a coefficient of absorption of solar radiation of at least 90 percent. Moreover, in some embodiments, top layer 208 has a coefficient of absorption of solar radiation of at least 95 percent.

In the exemplary embodiment, matrix 212 is one of a metal-based matrix, a ceramic-based matrix, and a combination thereof. For example, matrix 212 includes any of the metal-based (M2)CrX compositions as described above. For another example, matrix 212 includes any of the ceramic-based (M1)AX phases as described above and/or at least one of SiO₂, Al2O₃, TiO2, and ZrO2. Additionally or alternatively, a ceramic-based matrix used for matrix 212 is derived from pre-ceramic polymers via a heat treatment, for example from silicon-based pre-ceramic polymers in the Si-O-C-N-B system. In some embodiments, an operational lifetime of component 200 including a polymer-derived ceramic in matrix 212 of top layer 208 is increased, as compared to components using known coating systems that include polymer-derived ceramic materials, by an improved structural stability of base layer 206 formed from the materials described above. In alternative embodiments, matrix 212 includes any suitable combination of metal-based and/or ceramic-based materials. More specifically, in some embodiments, matrix 212 includes one or more metal-based materials, while in other embodiments, matrix 212 includes one or more oxide ceramic-based materials, and in still other embodiments, matrix 212 includes at least one metal-based material and at least one ceramic-based material.

In alternative embodiments, top layer 208 is any suitable composition that enables coating system 202 to function as described herein.

In certain embodiments, a thickness of top layer 208 is in a range from about 2 µm to about 50 µm. For example, the thickness of top layer 208 is in a range from about 2 µm to about 20 µm to facilitate effective absorption of solar radiation and improved structural stability of coating system 202. For another example, the thickness of top layer 208 is in a range from about 10 µm to 30 µm to facilitate effective absorption of solar radiation and improved structural stability of coating system 202. In some embodiments, the thickness of top layer 208 in a range from about 20 µm to about 30 µm particularly facilitates effective absorption of solar radiation and improved structural stability of coating system 202. In alternative embodiments, the thickness of top layer 208 is in any suitable range that enables coating system 202 to function as described herein.

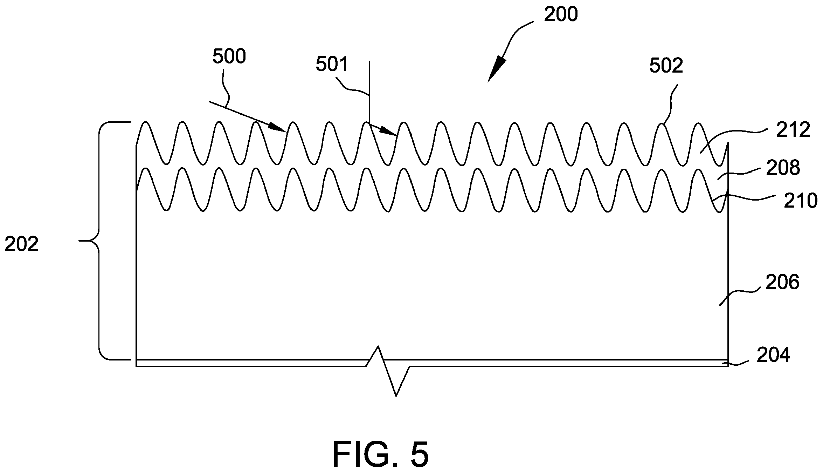

In some embodiments, top layer 208 has a surface roughness configured to increase absorption of solar radiation, one example of which is illustrated in FIG. 5 and discussed further below. In alternative embodiments, top layer 208 has any suitable surface roughness that enables coating system 202 to function as described herein.

In the exemplary embodiment, top layer 208 is disposed on outer surface 210 of base layer 206 by any suitable method, such as but not limited to cold gas spray (GDCS), thermal spray (e.g., atmospheric plasma spray (APS), high velocity oxygen fuel (HVOF), or high velocity air fuel (HVAF)), wire-arc spray, plasma electrolytic oxidation (PEO), electroplating, electroless plating, sheet brazing, laser cladding, slurry-based methods, paint brushing, air brushing, sponge brushing, dip coating, electrophoretic deposition, chemical vapor deposition (CVD), physical vapor deposition (PVD), or any combination thereof. In the exemplary embodiment, top layer 208 is formed as a single layer. In alternative embodiments, top layer 208 is formed with multiple layers, one example of which is illustrated in FIG. 4 and discussed further below.

FIG. 3 is a schematic cross-sectional view of a portion of another exemplary embodiment of component 200. In the illustrated embodiment, component 200 is as described in FIG. 2 except that base layer 206 includes a plurality of base layers 300, such as a first base layer 302 and a second base layer 304. Although only two base layers 302 and 304 are illustrated, in alternative embodiments plurality of base layers 300 includes any suitable number of base layers 300 that enables coating system 202 to function as described herein.

Plurality of base layers 300 are formed from the materials described above with respect to base layer 206. In the exemplary embodiment, at least one material property varies among the individual base layers 300. For example, a porosity of first base layer 302 differs from a porosity of second base layer 304. Alternatively, any suitable material property, or combination of material properties, varies among at least some of base layers 300.

For example, first base layer 302 is formed from at least one (M1)AX-phase material and second base layer 304 of base layer 206 is formed from at least one (M2)CrX composition. For another example, first base layer 302 is formed from at least one (M2)CrX composition and second base layer 304 is formed from at least one (M1)AX-phase material. For another example, first base layer 302 is formed from at least a first (M1)AX-phase material, and second base layer 304 is formed from at least a second (M1)AX-phase material. For another example, first base layer 302 is formed from at least a first (M2)CrX composition, and second base layer 304 is formed from at least a second (M2)CrX composition. Alternatively, each base layer 300 is formed from any material or combination of materials that enables coating system 202 to function as described herein.

FIG. 4 is a schematic cross-sectional view of a portion of another exemplary embodiment of component 200. In the illustrated embodiment, component 200 is as described in FIG. 2 except that top layer 208 includes a plurality of top layers 400, such as a first top layer 402 and a second top layer 404. Although only two top layers 402 and 404 are illustrated, in alternative embodiments plurality of top layers 400 includes any suitable number of top layers 400 that enables coating system 202 to function as described herein.

Plurality of top layers 400 are formed from the materials described above with respect to top layer 208. In the exemplary embodiment, each of plurality of top layers 400 has a different composition, such that at least one material property varies among the individual top layers 400. For example, first top layer 402 adjacent to base layer 206 is formed from a composition selected, as compared to others of top layers 400, to have a relatively high adhesiveness to base layer 206. For another example, second top layer 404 forming an outer surface of top layer 208 is formed from a composition selected, as compared to others of top layers 400, to have a relatively higher absorptivity and a relatively lower emissivity. Alternatively, any suitable material property, or combination of material properties, varies among at least some of top layers 400.

For example, matrix 212 of first top layer 402 is formed from at least one metal-based composition and matrix 212 of second top layer 404 is formed from at least one ceramic-based composition. For another example, matrix 212 of first top layer 402 is formed from at least one ceramic-based composition and matrix 212 of second top layer 404 is formed from at least one metal-based composition. For another example, matrix 212 of first top layer 402 is formed from at least a first metal-based composition, and matrix 212 of second top layer 404 is formed from at least a second metal-based composition. For another example, matrix 212 of first top layer 402 is formed from at least a first ceramic-based composition, and matrix 212 of second top layer 404 is formed from at least a second ceramic-based composition. Alternatively, each top layer 400 is formed from any material or combination of materials that enables coating system 202 to function as described herein.

Although coating system 202 having plurality of base layers 300 and coating system 202 having plurality of top layers 400 are illustrated separately in FIGs. 3 and 4, it should be understood that in some embodiments, coating system 202 includes both plurality of base layers 300 and plurality of top layers 400 each as described above.

FIG. 5 is a schematic cross-sectional view of a portion of another exemplary embodiment of component 200. In the illustrated embodiment, component 200 is as described in FIG. 2 except that an outer surface 502 of top layer 208 has a surface roughness configured to increase absorption of solar radiation. For example, a first light ray 500 approaches top layer 208 at a shallow angle, such that first light ray 500 would be reflected away from a smooth outer surface 502. The surface roughness of outer surface 502 causes first light ray 500 to be absorbed. For another example, a second light ray 501 approaches top layer 208 at an approximately 90 degree angle, but initially encounters a local point on roughened outer surface 502 at a shallow incidence angle. The surface roughness does not inhibit absorption of second light ray 501, as second light ray 501 is reflected from the initial incidence point to another portion of outer surface 502 at an angle that facilitates absorption. Thus, roughened outer surface 502 facilitates increased absorption of solar energy by causing incident solar radiation to reflect multiple times on outer surface 502.

In some embodiments, the roughness of outer surface 502 is formed during deposition of top layer 208. In other embodiments, the roughness of outer surface 502 is formed at least partially in a post-deposition process.

In some embodiments, a surface roughness of outer surface 502 of top layer 208 is characterized by a maximum roughness profile height ("Rz") and a mean spacing of profile irregularities ("RSm"), as defined in ISO 4287, *Geometrical Product Specifications (GPS)* - *Surface texture: Profile method* - *Terms, definitions and surface texture parameters* (1997). In the exemplary embodiment, Rz is in a range from about 10 µm to 200 µm, and Rz is greater than 0.1 multiplied by RSm. In alternative embodiments, Rz and Rsm have any suitable values that enable top layer 208 to function as described herein, such as but not limited to values that describe a relatively smooth outer surface 502.

Although outer surface 502 of top layer 208 having a relatively increased surface roughness is illustrated in FIG. 5 as used in combination with each of base layer 206 and top layer 208 having single layers, it should be understood that in some embodiments, coating system 202 includes outer surface 502 of top layer 208 having the relatively increased surface roughness in combination with either or both of plurality of base layers 300 and plurality of top layers 400 illustrated respectively in FIGs. 3 and 4.

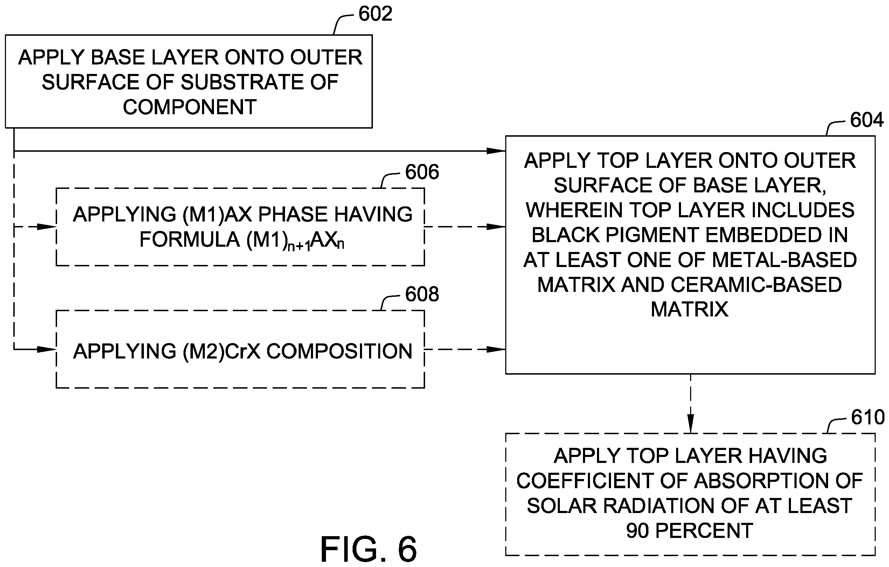

FIG. 6 is a flow chart of an exemplary method 600 of making a component, such as component 200. For example, the component could be used with a solar power system, such as solar power system 100. In the exemplary embodiment, method 600 includes applying 602 a base layer, such as base layer 206, onto an outer surface of a substrate of the component, such as outer surface 205 of substrate 204. The base layer includes at least one of a (M1)AX phase and a (M2)CrX composition. Method 600 also includes applying 604 a top layer, such as top layer 208, onto an outer surface of the base layer, such as outer surface 210. The top layer includes a black pigment embedded in a matrix, such as black pigment 213 embedded in matrix 212. The matrix is at least one of a metal-based matrix and a ceramic-based matrix.

In some embodiments, the step of applying 602 the base layer includes applying 606 the (M1)AX phase having a formula (M1)ₙ₊₁AXₙ, in which n =1, 2 or 3; M1 includes one of Ti, V, Cr, Zr, Nb, Mo, Hf, Sc, and Ta; A includes one of Al, Si, P, S, Ga, Ge, As, Cd, In, Sn, Tl, and Pb; and X includes at least one of C and N. Additionally or alternatively, in certain embodiments, the step of applying 602 the base layer includes applying 608 the (M2)CrX composition, in which M2 includes at least one of Ni, Co, and Fe, and X includes at least one of Al, Ti, Si, Ta, Nb, Mo, W, Mn, Y, and B. Additionally or alternatively, in some embodiments, the step of applying 604 the top layer includes applying 610 the top layer having a coefficient of absorption of solar radiation of at least 90 percent.

### EXAMPLES

The following laboratory test examples of coating system 202 are provided by way of illustration. However, these examples do not limit the application of the disclosure.

For example 1, components 200 were formed using substrate 204 implemented as an ASTM A213 T91 steel alloy, and also an Inconel 617 alloy. Coating system 202 was applied to each substrate 204 and included base layer 206 having two base layers 300. More specifically, first base layer 302 was implemented as a first (M2)CrX composition formed from a NiCrAlSiTaY composition, and second base layer 304 was implemented as a second (M2)CrX composition formed from a NiCrCoAISiTaY composition. Both base layers 300 were disposed on substrate 204 using an atmospheric plasma spray (APS) method, such that base layer 206 had a total thickness of 350 µm. Top layer 208 was formed from a commercially available black paint and disposed on base layer 206 using a sponge brush method, such that top layer 208 had a thickness in a range of about 2 µm to about 20 µm. Furnace cycle testing of components 200 to a temperature range of about 600°C to about 700°C simulating 8,800 hours of operational life demonstrated a more stable performance, in terms of microstructure integrity and solar absorptivity, of coating system 202 as compared to known coating systems.

For example 2, components 200 again were formed using substrate 204 implemented as an ASTM A213 T91 steel alloy, and also an Inconel 617 alloy. Coating system 202 was applied to each substrate 204 and included base layer 206 implemented as a (M2)CrX composition formed from a NiCrAlSiTaY composition, and disposed on substrate 204 using an APS method, such that base layer 206 had a thickness in a range of about 100 µm to about 200 µm. Top layer 208 was again formed from a commercially available black paint and disposed on base layer 206 using an air-brush method, such that top layer 208 had a thickness in a range of about 10 µm to about 30 µm. Furnace cycle testing of components 200 to a temperature range of about 600°C to about 700°C simulating 3,300 hours of operational life demonstrated a more stable performance, in terms of microstructure integrity and solar absorptivity, of coating system 202 as compared to known coating systems.

The above-described embodiments of coated components overcome at least some disadvantages of known coatings for components, such as components for solar power systems. Specifically, the embodiments include a coating system that includes a base layer tailored for resistance to oxidation and corrosion of the component substrate, and for resistance to cracking in high temperature environments. The coating system also includes a top layer tailored for high absorptivity of solar radiation and low emissivity, such that the base layer need not contribute substantially to the absorptivity of the coating. Also specifically, in some embodiments, a topography of an outer surface of the base layer is configured to improve adherence of the top layer through mechanical interlocking. Also specifically, in certain embodiments, the top layer has a surface roughness configured to improve absorptivity. Also specifically, in certain embodiments, the base layer and/or the top layer includes multiple layers, and a composition of some of the multiple layers is further tailored to improve at least one material property of the layer.

Exemplary embodiments of coated components and methods of making the components are described above in detail. The systems and methods are not limited to the specific embodiments described herein, but rather, components of systems and/or steps of methods may be utilized independently and separately from other components and/or steps described herein. For example, the coating system may also be used in combination with other machines and methods, and is not limited to practice with only a solar power system as described herein. Rather, the embodiments can be implemented and utilized in connection with many other high-temperature applications.

Although specific features of various embodiments of the disclosure may be shown in some drawings and not in others, this is for convenience only. Moreover, references to "one embodiment" in the above description are not intended to be interpreted as excluding the existence of additional embodiments that also incorporate the recited features. In accordance with the principles of the disclosure, any feature of a drawing may be referenced and/or claimed in combination with any feature of any other drawing.

This written description uses examples, including the best mode, to illustrate the disclosure and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Various aspects and embodiments of the present invention are defined by the following clauses:
1. A component comprising:
   a substrate; and
   a coating system comprising:
      a base layer comprising at least one of a (M1)AX phase and a (M2)CrX composition; and
      a top layer comprising a black pigment embedded in a matrix, wherein said matrix is at least one of a metal-based matrix and a ceramic-based matrix.
2. The component of Clause 1, wherein said base layer comprises said (M1)AX phase having a formula (M1)ₙ₊₁AXₙ, wherein
   n = 1, 2 or 3,
   M1 comprises one of Ti, V, Cr, Zr, Nb, Mo, Hf, Sc, and Ta,
   A comprises one of Al, Si, P, S, Ga, Ge, As, Cd, In, Sn, Tl, and Pb, and
   X comprises at least one of C and N.
3. The component of Clause 1, wherein said base layer comprises said (M2)CrX composition comprising:
   M2 comprising at least one of Ni, Co, and Fe; and
   X comprising at least one of Al, Ti, Si, Ta, Nb, Mo, W, Mn, Y, and B.
4. The component of Clause 1, wherein said base layer has a thickness in a range from about 30 µm to about 500 µm.
5. The component of Clause 1, wherein an outer surface of said top layer has a maximum roughness profile height Rz and a mean spacing of profile irregularities RSm, wherein Rz is in a range from about 10 µm to about 200 µm, and wherein Rz is greater than 0.1 multiplied by RSm.
6. The component of Clause 1, wherein said top layer has an absorption coefficient of solar radiation of at least 90 percent.
7. The component of Clause 1, wherein said base layer comprises an outer surface in contact with said top layer, said outer surface configured to mechanically interlock with said top layer.
8. The component of Clause 1, wherein said top layer has a thickness in a range of about 2 µm to about 50 µm.
9. A solar power system comprising:
   a central solar receiver comprising at least one heat exchanger component; and
   at least one heliostat configured to reflect solar energy toward said central solar receiver, wherein said at least one heat exchanger component comprises:
      a substrate; and
      a coating system comprising:
         a base layer comprising at least one of a (M1)AX phase and a (M2)CrX composition; and
         a top layer having a coefficient of absorption of solar radiation of at least 90 percent.
10. The solar power system of Clause 9, wherein said (M1)AX phase comprises (M1)ₙ₊₁AXₙ, wherein
   n = 1, 2 or 3,
   M1 comprises one of Ti, V, Cr, Zr, Nb, Mo, Hf, Sc, and Ta,
   A comprises one of Al, Si, P, S, Ga, Ge, As, Cd, In, Sn, Tl, and Pb, and
   X comprises at least one of C and N.
11. The solar power system of Clause 9, wherein said (M2)CrX composition comprises:
   M2 comprising at least one of Ni, Co, and Fe; and
   X comprising at least one of Al, Ti, Si, Ta, Nb, Mo, W, Mn, Y, and B.
12. The solar power system of Clause 9, wherein said base layer has a thickness in a range from about 30 µm to about 500 µm.
13. The solar power system of Clause 9, wherein said top layer comprises a black pigment embedded in a matrix, wherein said matrix is at least one of a metal-based matrix and a ceramic-based matrix.
14. The solar power system of Clause 9, wherein an outer surface of said top layer has a maximum roughness profile height Rz and a mean spacing of profile irregularities RSm, wherein Rz is in a range from about 10 µm to about 200 µm, and wherein Rz is greater than 0.1 multiplied by RSm.
15. The solar power system of Clause 9, wherein said top layer has the coefficient of absorption of solar radiation of at least 95 percent.
16. The solar power system of Clause 9, wherein said base layer comprises an outer surface in contact with said top layer, said outer surface configured to mechanically interlock with said top layer.
17. A method of making a component, said method comprising:
   applying a base layer onto an outer surface of a substrate of the component, wherein the base layer includes at least one of a (M1)AX phase and a (M2)CrX composition; and
   applying a top layer onto an outer surface of the base layer, wherein the top layer includes a black pigment embedded in a matrix, wherein the matrix is at least one of a metal-based matrix and a ceramic-based matrix.
18. The method of Clause 17, wherein applying the base layer comprises applying the (M1)AX phase having a formula (M1)ₙ₊₁AXₙ, wherein
   n =1, 2 or 3,
   M1 includes one of Ti, V, Cr, Zr, Nb, Mo, Hf, Sc, and Ta,
   A includes one of Al, Si, P, S, Ga, Ge, As, Cd, In, Sn, Tl, and Pb, and
   X includes at least one of C and N.
19. The method of Clause 17, wherein applying the base layer comprises applying the (M2)CrX composition, and wherein
   M2 includes at least one of Ni, Co, and Fe, and
   X includes at least one of Al, Ti, Si, Ta, Nb, Mo, W, Mn, Y, and B.
20. The method of Clause 17, wherein applying the top layer comprises applying the top layer having a coefficient of absorption of solar radiation of at least 90 percent.

## Claims

1. A component (200) comprising:
a substrate (204); and
a coating system (202) comprising:
a base layer (206) comprising at least one of a (M1)AX phase and a (M2)CrX composition; and
a top layer (208) comprising a black pigment (213) embedded in a matrix (212),
wherein said matrix is at least one of a metal-based matrix and a ceramic-based matrix.

2. The component (200) of Claim 1, wherein said base layer (206) comprises said (M1)AX phase having a formula (M1)n+1AXn, wherein
n = 1, 2 or 3,
M1 comprises one of Ti, V, Cr, Zr, Nb, Mo, Hf, Sc, and Ta,
A comprises one of Al, Si, P, S, Ga, Ge, As, Cd, In, Sn, Tl, and Pb, and
X comprises at least one of C and N.

3. The component (200) of Claim 1 or 2, wherein said base layer (206) comprises said (M2)CrX composition comprising:
M2 comprising at least one of Ni, Co, and Fe; and
X comprising at least one of Al, Ti, Si, Ta, Nb, Mo, W, Mn, Y, and B.

4. The component (200) of any one of Claims 1 to 3, wherein said base layer (206) has a thickness in a range from about 30 µm to about 500 µm.

5. The component (200) of any one of Claims 1 to 4, wherein an outer surface (205) of said top layer (208) has a maximum roughness profile height Rz and a mean spacing of profile irregularities RSm, wherein Rz is in a range from about 10 µm to about 200 µm, and wherein Rz is greater than 0.1 multiplied by RSm.

6. The component (200) of any one of Claims 1 to 5, wherein said top layer (208) has an absorption coefficient of solar radiation of at least 90 percent.

7. The component (200) of any one of Claims 1 to 6, wherein said base layer (206) comprises an outer surface (210) in contact with said top layer (208), said outer surface configured to mechanically interlock with said top layer.

8. The component (200) of any one of Claims 1 to 7, wherein said top layer (208) has a thickness in a range of about 2 µm to about 50 µm.

9. A solar power system (100) comprising:
a central solar receiver (120) comprising at least one heat exchanger component (160); and
at least one heliostat (180) configured to reflect solar energy toward said central solar receiver, wherein said at least one heat exchanger component comprises:
a substrate (204); and
a coating system (202) comprising:
a base layer (206) comprising at least one of a (M1)AX phase and a (M2)CrX composition; and
a top layer (208) having a coefficient of absorption of solar radiation of at least 90 percent.

10. The solar power system (100) of Claim 9, wherein said (M1)AX phase comprises (M1)n+1AXn, wherein
n = 1, 2 or 3,
M1 comprises one of Ti, V, Cr, Zr, Nb, Mo, Hf, Sc, and Ta,
A comprises one of Al, Si, P, S, Ga, Ge, As, Cd, In, Sn, Tl, and Pb, and
X comprises at least one of C and N.

11. The solar power system (100) of Claim 9 or 10, wherein said (M2)CrX composition comprises:
M2 comprising at least one of Ni, Co, and Fe; and
X comprising at least one of Al, Ti, Si, Ta, Nb, Mo, W, Mn, Y, and B.

12. The solar power system (100) of any one of Claims 9 to 11, wherein said base layer (206) has a thickness in a range from about 30 µm to about 500 µm.

13. The solar power system (100) of any one of Claims 9 to 12, wherein said top layer (208) comprises a black pigment (213) embedded in a matrix (212), wherein said matrix is at least one of a metal-based matrix and a ceramic-based matrix.

14. The solar power system (100) of any one of Claims 9 to 13, wherein an outer surface (205) of said top layer (208) has a maximum roughness profile height Rz and a mean spacing of profile irregularities RSm, wherein Rz is in a range from about 10 µm to about 200 µm, and wherein Rz is greater than 0.1 multiplied by RSm.

15. The solar power system (100) of any one of Claims 9 to 14, wherein said top layer (208) has the coefficient of absorption of solar radiation of at least 95 percent.
